Europäisches Patentamt

European Patent Office

Office européen des brevets

(11) Publication number: **0 474 375 A2**

## EUROPEAN PATENT APPLICATION

(21) Application number: **91307436.5**

(51) Int. Cl.$^5$: **H01L 41/20**

(22) Date of filing: **13.08.91**

(30) Priority: **01.09.90 GB 9019082**

(43) Date of publication of application:
**11.03.92 Bulletin 92/11**

(84) Designated Contracting States:
**AT BE CH DE DK ES FR GB GR IT LI LU NL SE**

(71) Applicant: **JOHNSON MATTHEY PUBLIC LIMITED COMPANY**
**78 Hatton Garden**
**London, EC1N 8JP (GB)**

(72) Inventor: **Hall, William Garfield**
**The Oaks, The Green South**
**Warborough, Oxon OX10 7DR (GB)**
Inventor: **Westwood, Philip**
**Coachmans, Holmwood, Binfield Heath**
**Henley-on-Thames, Oxon RG9 4DP (GB)**

(74) Representative: **Wishart, Ian Carmichael et al**
**Patents Department Johnson Matthey**
**Technology Centre Blounts Court Sonning**
**Common**
**Reading, Berks RG4 9NH (GB)**

(54) **Improvements in materials.**

(57) A magnetostrictive rod, e.g. of Terfenol-D, is improved by having ends of different composition from the central portion, the end composition providing improved mechanical properties. Less physical degradation of the ends, e.g. flaking when used in an actuator, is exhibited.

EP 0 474 375 A2

This invention concerns improvements in materials, more especially it concerns improved rare earth-iron alloys having magnetomechanical properties.

It is known that rare earth-iron alloys have magnetomechanical properties, and reference is made to USP's 3,949, 351, 4,308,474 and 4,378,258, and to USP 4,609,402 which described a method of making grain oriented rods. The giant magnetostrictive material known as "Terfenol-D", having the nominal composition $Tb_{0.3} Dy_{0.7} Fe_2$, is being studied by several research groups and is commercially available albeit in rather small quantities.

Significant commercial use of the giant magnetostrictives has not yet commenced despite the materials having been discovered some 20 years ago, and despite the unique properties exhibited by this class of materials. Terfenol-D is extremely brittle, and can physically degrade in use. In particular, rods and other pieces of Terfenol-D show a tendency to flake at the ends where the rods interact with parts of devices incorporating them, such as actuators.

The strain exhibited by Terfenol-D is dependant upon applied stress, and may be increased by 50% or more by stressing the rod or piece of Terfenol-D. In general, stressing the rod or piece of Terfenol-D requires the ends to be clamped or otherwise retained, and it is frequently at this point that flaking occurs. It is an aim of the present invention to reduce or eliminate degradation of rods or pieces of such materials. Because of the considerable dimensional changes demonstrated by magnetostrictive material and the nature of the alloy it is difficult to attach a part of tougher material thereto by brazing, welding or adhesives. Brazing or welding carry the risk of creating even more brittle phases and is generally magnetically deleterious. In general, any form of attachment as could normally be used for joining parts of dissimilar material would have to show such capability to cope with the dimensional changes as would most likely degrade the mechanical performance of the magnetostrictive material.

Herein, the general term magnetostrictive will be used to apply to materials which exhibit a change of dimension when subjected to a change in magnetic field, whether that change is an increase or decrease in dimension.

The present invention provides a magnetostrictive rare earth-iron material in elongate form and having first and second ends and a central portion, characterised in that at least one end is a different composition from that forming the bulk of the central portion, said different composition being such as to provide an improved mechanical property.

The magnetostrictive rare earth-iron material is known from the literature and patent literature to have the approximate general formula $RFe_2$, where R is one or more rare earths especially Dy, Tb, Ho, Er, Pr, Sm and Tm. As is known from the literature, the iron and rare earths should be substantially pure, with preferably less than 0.1% by weight of impurities in the alloy feedstock. Also, as known from the literature, the material in elongate form has preferably been zone refined and preferably has been grain oriented in the elongate direction of the material. For ease of reference, hereinafter the elongate material will be described as a "rod", and it is to be understood that this term refers to rods of any cross-sectional shape, for example circular, polyangular, annular, or a composite material comprising laminae of the magnetostrictive material.

We have discovered that by relative small changes in composition, that do not cause mechanical failure within the rods, a tougher end can be created. The changed composition does not exhibit the maximum magnetostrictive effect possible for the components of the composition, but effectively transmits the movement of the bulk of the rod. In general, the composition of the bulk of the rod will be optimised for maximum strain, and that of the end(s) will be optimised for sufficient toughness to be clamped, machined to form an external or internal thread, drilled or otherwise mechanically modified, so as to improve the interaction between the rod and a device or to minimise degradation of the rod.

For example, an optimised composition for maximum strain at room temperature is $Tb_{0.27} Dy_{0.73} Fe_{1.9}$ and this may form the bulk of a rod according to the invention. The ends of the rod are suitably a composition R $Fe_x$ in which x is less than 1.9, preferably less than 1.8, especially less than 1.7. The compressive strength of a composition $Tb_{0.27} Dy_{0.73} Fe_{1.7}$ was measured to be 37% greater than that of $Tb_{0.27} Dy_{0.73} F_{1.9}$, although the end compositions exhibit lower strain and coupling coefficients.

It is possible to manufacture the rods according to the invention by a batch process. Suitably, feedstock alloys of the desired composition are fed into a contained vertical casting tube, in the desired amounts and order. Thus, pieces of end composition alloy are positioned in the bottom of the casting tube, followed by bulk composition pieces, and then topped off with a further charge of end composition. A vertically ascending annular RF induction heater, operating under such conditions to cause a zone of molton metal to be formed in the casting tube, is moved upwards from the bottom of the casting tube, causing the end composition to melt and be cast and, at the interface, to blend into the bulk composition, with a similar blending at the interface with the upper end composition. An integral rod is produced which had ends of higher compressive strength, permitting clamping of the ends to take place. Substantially improved resistance to flaking was exhibited after extended use in an actuator or where the rod was required to operate for a short period under extreme conditions.

The invention is capable of considerable variation in compositions chosen, and the methods used to form the rod of the invention, and all such variations are considered to be within the scope of the invention. For example, the composition of the ends of the rod may vary one from another, or, for a particular application, one of the ends may be the same composition as the bulk of the rod. The invention is believed to be applicable to all rare earth-iron magnetostrictive alloys, although the invention is described herein with particular reference to the Terfenol-D composition. The composition of the bulk of the rod will be chosen for the particular intended use and will tend to be a balance between strain and coupling coefficient (as the primary indications of magnetostriction), resistance to the working environment, cost and the temperature range for operation. The end compositions may be chosen to give the desired mechanical properties and therefore magnetomechanical properties are very much less of an influence on choosing an end composition.

The invention is illustrated with reference to the accompanying micrographs, which show impact damage to the ends of magnetostrictive rods.

Figure 1a shows the end of a standard rod before impact testing.

Figure 1b shows the same end after impact testing.

Figure 2a shows the end of a rod according to the invention before impact testing, and

Figure 2b shows the same end after impact testing.

The invention is further described in the following Example, which is intended to be illustrative and not restrictive of the scope of the present invention.

## EXAMPLE

Two sample magnetostrictive rods of 10mm diameter and 90mm length were prepared by machining rods produced by the batch process described above. One rod was composed entirely of $Tb_{0.27}Dy_{0.73}Fe_{1.9}$ ("$RFe_{1.9}$"), and the other has similar composition along approximately 60mm of its length, with two approximately 15mm ends of $Tb_{0.27}Dy_{0.73}Fe_{1.5}$("$RFe_{1.5}$"). Apart from the compositions, the rods were prepared in identical manner.

Following magneto-mechanical property measurement, both rods were evaluated by multiple low impact test comprised dropping each rod through a 10.6mm internal diameter x 50mm long quartz guide tube from a vertical height of 5mm onto a steel slab. Damage to the end of each rod was assessed following a series of 880 impact tests, and the micrographs of the Figures were made.

## RESULTS:

### MAGNETO-MECHANICAL:

| ROD | Max $k_{33}$ | MAXIMUM STRAIN ppm | | |
|---|---|---|---|---|
| | | @ 5MPa | @ 10MPa | @ 20MPa |
| $RFe_{1.9}$ | 0.594 | 880 | 1000 | 1100 |
| $RFe_{1.5/1.9}$ | 0.550 | 700 | 760 | 820 |

Notes:

1. The properties of the rods with ~15mm long ends of $Fe_{1.5}$ are illustrative rather than optimised for the best balance between magneto-mechanical properties and damage resistance.

2. Values for maximum $k_{33}$ are uncorrected and were obtained from the whole rod.

**IMPACTS TESTS**

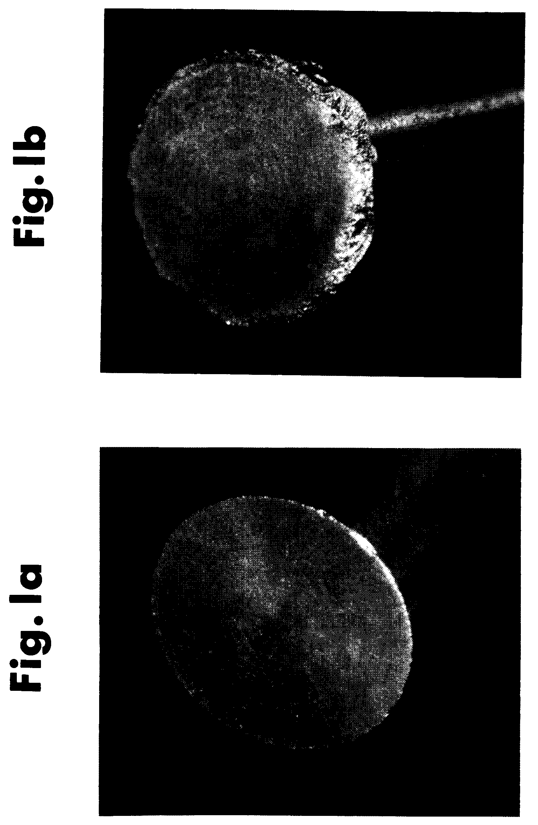

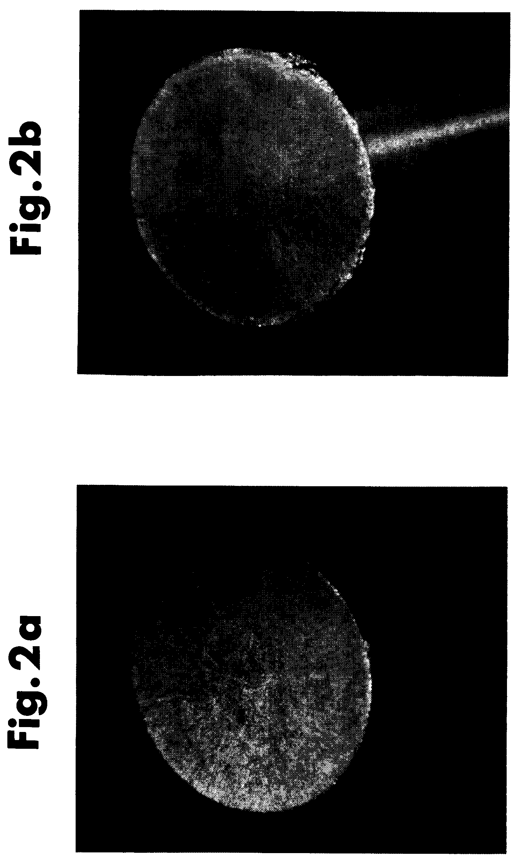

It can clearly be seen from the damaged ends of Figures 1b and 2b, that the rod according to the invention (2b) exhibited superior resistance to damage compared to the rod of conventional composition (1b).

**Claims**

1. A magnetostrictive rare earth-iron rod having first and second ends and a central portion, characterised in that at least one end is a different composition from that forming the bulk of the central portion, said different composition being such as to provide an improved mechanical property.

2. A rod according to claim 1, wherein the material of the central portion has the approximate general formula $RFe_2$ in which R is one or more rare earths selected from Dy, Tb, Ho, Er, Pr, Sm and Tm.

3. A rod according to claim 2, wherein the composition of at least one end is $RFe_x$, in which x has a value of less than 1.9.

4. A rod according to claim 3, wherein in the end composition $RFe_x$, x has a value of less than 1.8.

5. A rod according to claim 4, wherein in the end composition $RFe_x$, x has a value of less than 1.7.

6. A rod according to any one of the preceding claims, wherein the central portion is Terfenol-D.

7. A rod according to claim 1, substantially as hereinbefore described.

8. A rod according to any one of the preceding claims, used in an actuator.

9. A method of manufacturing a rod according to any one of claims 1 to 7, comprising casting the rod using a different composition for at least one end from that of the central portion, and causing the end and central compositions to blend at the interface.

10. A method according to claim 9, wherein pieces of material of the desired composition are loaded into a vertical casting tube and are zone melted to produce a cast rod.

Fig. 1a

Fig. 1b

# Fig.2a

# Fig.2b

EP 0 474 375 A2